# EUROPEAN PATENT APPLICATION

(11) **EP 1 811 526 A1**
(43) Date of publication of application: **25.07.2007**
(21) Application number: 05766366.8
(22) Date of filing: 22.07.2005
(51) Int. Cl.: G12B 5/00, H01L 21/027, H01L 21/68, F16C 32/06

(54) **SUPPORT DEVICE, STAGE DEVICE, EXPOSURE DEVICE, AND DEVICE MANUFACTURING METHOD**

(30) Priority: 23.07.2004 JP 2004215434
(71) Applicant: NIKON CORPORATION, Tokyo 100-8331 (JP)
(72) Inventor: ICHINOSE, Go NIKON CORPORATION,, Tokyo 100-8331 (JP); SHIBAZAKI, Yuichi NIKON CORPORATION,, Tokyo 100-8331 (JP)
(74) Representative: HOFFMANN EITLE
(86) International application number: PCT/JP2005/013496
(87) International publication number: WO 2006/009254

(57) **Abstract**

A support apparatus, a stage apparatus, an exposure apparatus, etc. are proposed that can increase response of a relative movement between a piston and a cylinder, etc. are proposed. There is provided a support apparatus (300) including: a cylinder portion (311); a piston portion (312) that is provided inside the cylinder portion (311) and is movable in a Z direction; a fluid bearing (307) formed in at least a portion between an inner wall (311 c) of the cylinder portion (311) and an outer wall (312d) of the piston portion (312), the support apparatus supporting a supported member (42) in the Z direction with respect to a support member (43) by means of a biasing force generated by the cylinder portion (311) and the piston portion (312), in which fluids (G1, G2) are supplied independently inside the fluid bearing (307) and the cylinder (311).

## Description

### TECHNICAL FIELD

The present invention relates to a support apparatus that supports an object, a stage apparatus that supports the support apparatus, and an exposure apparatus provided with the stage apparatus etc.

This application claims priority to Japanese Patent Application No. 2004-215434, filed July 23, 2004, the contents of which are incorporated herein by reference.

### BACKGROUND ART

In the photolithography process for manufacturing semiconductor devices, liquid crystal display devices, etc., a step-and-repeat type reduction projection exposure apparatus (also known as a stepper) in which a pattern formed on a mask or reticle (hereinafter generally referred to as a reticle) is projected via a projection optical system onto a photosensitive object such as a wafer or glass plate coated with a resist, etc. (hereinafter generally referred to as a wafer); and a step-and-scan type scanning exposure apparatus (also known as a scanning stepper) that is a modified version of the stepper, are mainly used.

In a projection exposure apparatus such as a stepper, a mainstream stage apparatus is one that includes: a table that holds a wafer; a stage that two-dimensionally moves on a horizontal plane while holding the table; and a two-axis linear motor that drives the stage. In the stage apparatus, the table is supported on the stage by for example, three support units. The support units allow the table to be finely inclined on the stage with respect to a horizontal plane.

As for a support unit, one disclosed in Japanese Unexamined Patent Publication, First Publication No. 2000-56483, etc. is known which includes: a self-weight support portion constituted by a piston-cylinder, etc.; and a drive portion constituted by a voice coil motor, etc., in which the self-weight support portion supports a table while compensating the self weight of the table and at the same time the drive portion finely moves the table in the direction of gravitational force. In such a support unit, the weight of the table is supported by a positive pressure of a gas. Thus, the weight of the table does not need to be supported by a voice coil motor, etc. Therefore, energy consumption can be tremendously reduced. As far as is permitted by the national law of the country specified (or selected) in this patent application, the Japanese patent publication below is incorporated herein by reference.
Patent Document: Japanese Unexamined Patent Publication, First Publication No. 2000-56483 (FIG. 4)

In the self-weight support portion of the above-described support unit, pressurized gas is supplied between the piston and the cylinder as well as inside the cylinder to pivotally support (horizontally restrain) the piston on the cylinder while at the same time moving the piston (in the direction of gravitational force) with respect to the cylinder.

However, this support unit has problems of, for example, insufficient response to the movement of the cylinder in the Z direction, etc., since pressurized gas supplied between the piston and the cylinder as well as inside the cylinder is supplied via the same gas supply system.

### DISCLOSURE OF INVENTION

The present invention has been achieved in view of the above circumstances, and has an object to propose a support apparatus, stage apparatus, exposure apparatus, etc. that can improve the response of relative movement between a piston and a cylinder.

A support apparatus, stage apparatus, exposure apparatus, and device manufacturing method according to the present invention adopt the following method to solve the above-mentioned problems. Note that parenthesized reference numerals affixed to the respective elements are merely examples of those elements, and they do not limit the respective elements.

An embodiment of a first aspect of the invention is a support apparatus (300) including: a cylinder portion (311); a piston portion (312) that is provided inside the cylinder portion and is movable in a first direction (Z); a fluid bearing (307) formed in at least a portion between an inner wall (311 c) of the cylinder portion and an outer wall (312d) of the piston portion, the support apparatus supporting a supported member (42) in the first direction with respect to a support member (43) by means of a biasing force generated by the cylinder portion and the piston portion, in which fluids (G1, G2) are supplied independently inside the fluid bearing and the cylinder, respectively.

According to this embodiment of the invention, a pivotal support of the piston portion by the cylinder portion and a relative movement of the piston portion with respect to the cylinder portion can be independent of each other. Therefore, response to a bias to the supported member by the piston portion and the cylinder portion can be improved.

Another embodiment of the support apparatus includes: a first supply apparatus (301) that supplies the fluid (G1) inside the cylinder portion (311); and a second supply apparatus (305) that supplies the fluid (G2) to the fluid bearing (307), in which a pressure of the fluid supplied from the first supply apparatus and a pressure of the fluid supplied from the second supply apparatus are different from each other. This can improve, for example, stiffness of a fluid bearing formed between the cylinder portion and the piston portion.

Another embodiment of the support apparatus includes a pressure chamber (313s) provided inside the cylinder portion (311), in which the first supply apparatus (301) supplies the fluid (G1) to the pressure chamber. This can obtain a biasing force by the fluid supplied to the pressure chamber.

Another embodiment of the support apparatus is one in which the pressure chamber (313s) is provided independently of the cylinder portion (311) and has an outer envelope (313) extendable in the first direction. This can efficiently convert the pressure of the fluid supplied to the pressure chamber into a biasing force in the first direction.

Another embodiment of the support apparatus is one in which the piston portion (312) is connected with the outer envelope (313). This can move the piston portion according to expansion and contraction of the outer envelope.

Another embodiment of the support apparatus is one in which the fluids (G1, G2) are prevented from moving between the pressure chamber (313s) and the fluid bearing (307). This can prevent the pressure chamber and the fluid bearing from being mutually affected by the pressure fluctuation, etc. of the other.

Another embodiment of the support apparatus is one in which the fluid bearing (307) has a porous body (306) provided on at least either one of the inner wall (311c) of the cylinder portion (311) and the outer wall (312d) of the piston portion (312), and the second supply apparatus (305) supplies the fluid (G2) to the porous body. This can easily form a gas bearing without the need to provide a groove, etc. on the inner wall of the cylinder portion.

Another embodiment of the support apparatus includes: an intermediate member (314) located on one end of the piston portion (312) and inclinable with respect to a plane that intersects the first direction (Z); and a second fluid bearing (303) formed between the piston portion and the intermediate member, in which the second bearing is supplied with the fluid (G1) and/or the fluid (G2) from at least either one of the first supply apparatus (301) and the second supply apparatus (305). This can allow the supported member to be supported inclinably with respect to the support member without the need to provide a new fluid supply apparatus.

Another embodiment of the support apparatus is one in which the intermediate member (314) has a support plane (314a) that supports a support member (43) or a supported member (42), and a relative movement is allowed between the support member or the supported member and the support plane with respect to a direction that intersects the first direction (Z). This can make the supported member movable in a direction that intersects the first direction with respect to the support member.

The support apparatus may be installed such that the cylinder portion (311) is connected with the support member (43).

The support apparatus may be installed such that the cylinder portion (311) is connected with the supported member (42).

Another embodiment of the support apparatus is one in which an actuator (330) that generates a force substantially parallel with the first direction (Z) is provided between the support member (43) or supported member (42) and the cylinder portion (311). This can precisely position-control the supported member in the first direction with respect to the support member.

An embodiment of a second aspect of the invention is a stage apparatus (40) including: a first member (43); and a second member (42) that is supported movably with respect to the first member by at least one support apparatus (300), in which the support apparatus is a support apparatus (300) according to the first aspect of the invention, and the second member includes at least a part of the supported member (42).

According to this embodiment of the invention, the position in the direction of gravitational force and the attitude of the second member with respect to the first member can be precisely controlled with a low power.

Another embodiment of the stage apparatus is a stage apparatus (80) movable on a base (81) with a guide face (81 a), including a support apparatus (300) according to the first aspect of the invention, the stage apparatus being supported on the base by means of the support apparatus. This can support the stage apparatus contactlessly and in a manner that compensates (cancels) the self weight of the stage, and at the same time can move the stage apparatus along the guide plane.

An embodiment of a third aspect of the invention is an exposure apparatus (EX) including: a mask stage (20) that holds a mask (R); and a substrate stage (40) that holds a substrate (W), the exposure apparatus exposing a pattern (PA) formed on the mask onto the substrate, in which the stage apparatus according to the second aspect of the invention is used for at least either one of the mask stage and the substrate stage. According to this embodiment of the invention, the mask or the substrate can be precisely controlled in the direction of gravitational force with a low power. Therefore, a pattern with a high degree of accuracy can be exposed onto the substrate.

An embodiment of a fourth aspect of the invention is a device manufacturing method including a lithography process, in which the exposure apparatus (EX) according to the third invention is used in the lithography process. According to this embodiment of the invention, devices with high performance can be manufactured.

With the present invention, the following advantages can be obtained.

Response to a bias to the supported member by the piston portion and the cylinder portion can be improved. Therefore, the position in the direction of gravitational force and the attitude of the supported member can be swiftly changed, Furthermore, stiffness of a fluid bearing formed between the cylinder portion and the piston portion can be improved with ease. Therefore, a relative movement between the piston portion and the cylinder portion can be smooth even if there is vibration in the horizontal direction, etc.

The position in the direction of gravitational force and the attitude of the supported member can be precisely controlled with a low power. Therefore, the exposure apparatus can set the relative position between the wafer and the mask with high precision. As a result, a high performance device with a fine pattern can be manufactured.

### BRIEF DESCRIPTION OF THE DRAWINGS

FIG. 1 is a schematic block diagram showing an embodiment of an exposure apparatus EX.
FIG. 2 is an enlarged view of a wafer stage 40.
FIG. 3 is a cross-sectional view showing a support apparatus 300.
FIG, 4A is a perspective view showing another example of use of the support apparatus 300.
FIG. 4B is a cross-sectional perspective view showing a configuration of a support apparatus 3 00' .
FIG. 5 is a cross-sectional view showing a configuration of a support apparatus 600.
FIG, 6A is a perspective view showing an air pad 400.
FIG. 6B is a perspective view showing a slot member 402.
FIG. 7 is a flowchart showing an example of manufacturing steps for micro devices.
FIG. 8 is a view showing an example of detailed steps in STEP S13 in the case of semiconductor devices.

### DESCRIPTION OF SYMBOLS

20: reticle stage (mask stage); 40: wafer stage (substrate stage, stage apparatus); 42: Z table (supported member, second member); 43: XY table (support member, first member); 80: stage apparatus; 81: wafer faceplate (base); 81a: guide face; 82: XYZ table; 300, 300', 600: support apparatus; 301: gas supply system (first supply apparatus); 303: aerostatic bearing (second fluid bearing); 304: aerostatic bearing (third fluid bearing); 305: gas supply system (second supply apparatus); 306: porous body; 307: aerostatic bearing (fluid bearing); 311: cylinder; 311c: inner peripheral surface (inner wall); 312: piston; 312d: outer peripheral surface (outer wall); 313:bellows (outer envelope); 313s: inner space (pressure chamber); 314: swivel (intermediate member); 330: drive portion (actuator); G1, G2: pressurized gas (fluid); R: reticle (mask); PA: pattern; W: wafer (substrate); EX: exposure apparatus

### BEST MODE FOR CARRYING OUT THE INVENTION

The following is a description of embodiments of a support apparatus, a stage apparatus, an exposure apparatus, and a device manufacturing method according to the present invention with reference to the drawings.

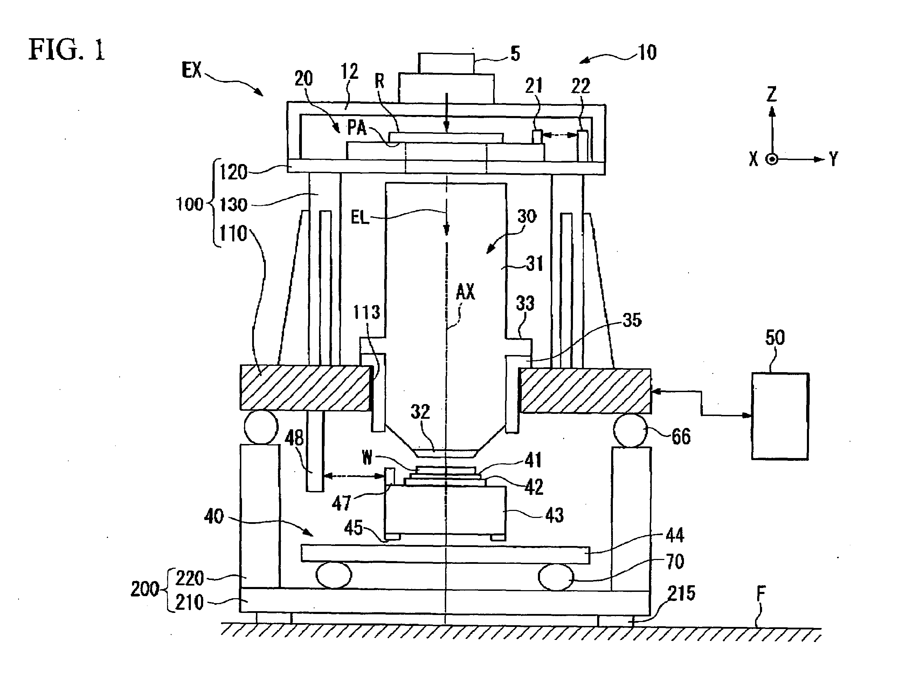

FIG. 1 is a schematic block diagram of an embodiment of an exposure apparatus according to the present invention.

The exposure apparatus EX is a step-and-scan type scanning exposure apparatus that while synchronously moving a reticle (mask) R and a wafer (substrate) W in a one-dimensional direction, transfers a pattern PA formed on the reticle R onto each shot region on the wafer W via a projection optical system 30, that is, also known as a scanning stepper.

The exposure apparatus EX includes: an illumination optical system 10 that illuminates the reticle R with an exposure light EL; a reticle stage 20 that holds the reticle R; a projection optical system 30 that projects the exposure light EL radiated from the reticle R onto the wafer W; and a wafer stage 40 that holds the wafer W; a control apparatus 50 that comprehensively controls the exposure apparatus EX.

Each of these apparatuses is supported on a main frame 100 or on a base frame 200 via vibration isolating units 66, 70, and the like.

In the description below, a direction that coincides with the optical axis AX of the projection optical system 30 is made the Z axis direction, a synchronous movement direction (scanning direction) of the reticle R and the wafer Z in a plane perpendicular to the Z axis direction is made the Y axis direction, and a direction perpendicular to the Z axis and Y axis directions (non-scanning direction) is made the X axis direction. Furthermore, rotation directions about the X axis, the Y axis and the Z axis, are made the θX, the θY, and the θZ directions, respectively.

The illumination optical system 10 illuminates the reticle R supported on the reticle stage 20 with the exposure light EL and has an exposure light source, an optical integrator for uniforming the illuminance of a light flux emitted from the exposure light source, a condenser lens for condensing the exposure light EL from the optical integrator, a relay lens system, a variable field stop for setting an illumination area on the reticle R formed by the exposure light EL to be of a slit-like shape, etc. (all of these not shown).

For the exposure light EL radiated from the illumination optical system 10, emission lines in the ultraviolet region (g-line, h-line, i-line) radiated from a mercury lamp, and ultraviolet light beams such as the KrF excimer laser beam (wavelength: 248 nm), the ArF excimer laser beam (wavelength: 193 nm) and the F₂ laser beam (wavelength: 157 nm), may be used.

The laser beam radiated from the light source 5 enters the illumination optical system 10. The cross-sectional shape of the laser beam is then shaped into a slit or a rectangle (polygon) while at the same time the laser beam is turned into an illumination light (exposure light) of a substantially uniform luminance distribution to be shone onto the reticle R.

The illumination optical system 10 is supported by an illumination system support member 12 fixed on the top surface of a second support plate 120 constituting the main frame 100.

The reticle stage (mask stage) 20 moves two-dimensionally in a plane perpendicular to the optical axis AX of the projection optical system 30, that is, the XY plane and finely rotates in the θZ direction while supporting the reticle R. It includes a reticle fine movement stage that holds the reticle R, a reticle rough movement stage that moves together with the reticle fine movement stage in the Y axis direction, that is, the scanning direction with a predetermined travel, a linear motor that moves these, etc. (all of these not shown). A rectangular opening is formed in the reticle fine movement stage. A reticle attraction mechanism provided around the opening holds the reticle by vacuum attraction, etc. Note that the reticle stage 20 does not need to be composed of the rough movement stage and the fine movement stage as mentioned above. It may be configured such that a single stage supports and positions (moves) the reticle R.

A movement mirror 21 is provided on the reticle stage 20. Furthermore, a laser interferometer 22 is provided at a position facing the movement mirror 21. The position in the two-dimensional direction and the rotation angle of the reticle R on the reticle stage 20 are measured by the laser interferometer 22 in real time, and the measurement results are outputted to the control apparatus 50. By driving the linear motor, etc. based on the measurement results from the laser interferometer 22, the control apparatus 50 performs positioning, etc. of the reticle R supported by the reticle stage 20.

The reticle stage 20 is suspendedly supported above the top surface of the second support plate 120 constituting the main frame 100 via a contactless bearing (e.g., aerostatic bearing) (not shown).

The projection optical system 30 project-exposes the pattern PA of the reticle R onto the wafer W at a predetermined projection magnification β. It is constituted by a plurality of optical elements including an optical element 32 provided at a tip end (lower end) on the wafer W side. These optical elements are supported in a lens barrel 31. The projection optical system 30 of this embodiment is a reduction system having the projection magnification β of, e.g., 1/4 or 1/5. The projection optical system PL may be either of an equal system and a magnifying system.

A flange 33 is provided on the outer wall of the lens barrel 31, The lens barrel 31 is inserted into a cylinder-shaped sensor support table 35 with a flange. The lens barrel 31 and the sensor support table 35 are inserted into and supported by a hole portion 113 provided in a first support plate 110 constituting the main frame 100. The first support plate 110 is held substantially horizontally above the base frame 200 via the vibration isolating unit 66.

The sensor support table is a member for supporting sensors such as an autofocus sensor. Between the first support plate 110 and the sensor support table 35, a kinematic mount is provided (not shown), which allows adjustment of a tilt angle of the projection optical system 30.

The wafer stage (substrate stage, stage apparatus) 40 moves two-dimensionally within the XY plane and rotates finely in the θZ direction while supporting the wafer W. It includes: a wafer holder 41 that holds the wafer W; a Z table 42 that finely drives the wafer holder 41 in directions of three degrees of freedom being the Z axis, θX, and θY directions for leveling and focusing the wafer W; an XY table 43 that continuously moves the Z table 42 in the Y axis direction while stepwise moving the Z table 42 in the X axis direction; a wafer faceplate 44 that movably supports the XY table 43 within the XY plane; a drive portion (not shown) that is constituted by a linear motor for moving the Z table 42 and the XY table 43 integrally in a parallel direction. Instead of the Z table 42, a fine movement table that is driven in six degrees of freedom with respect to the XY table 43 may be provided. In this case, a drive portion 330 may be constituted by, for example, two drive portions for the X axis, one drive portion for the Y axis, and three drive portions for the Z axis. However, the configuration is not limited thereto.

A movement mirror 47 is provided on the Z table 42. Furthermore, a laser interferometer 48 is provided at a position facing the movement mirror 47. The position in the two-dimensional direction and the rotation angle of the wafer W on the wafer stage 40 are measured by the laser interferometer 48 in real time, and the measurement results are outputted to the control apparatus 50. By driving the linear motor, etc. based on the measurement results from the laser interferometer 48, the control apparatus 50 positions the wafer W supported by the wafer stage 40.

A plurality of air bearings (air pads) 45 that are contactless bearings are fixed to the bottom surface of the XY table 43. By the air pads 45, the XY table is suspendedly supported above the wafer faceplate 44 with a clearance of, for example, about a several microns. The wafer faceplate 44 is supported substantially horizontally above the support plate 210 of the base frame 200 via the vibration isolating unit 70.

The control apparatus 50 comprehensively controls the exposure apparatus EX. It includes an operation portion for performing and controlling a variety of operations, and furthermore includes a memory portion for storing a variety of information, and an input/output portion.

The control apparatus 50, for example, controls the positions of the reticle R and the wafer W based on the detection results from the laser interferometers 22, 48 to repeatedly perform an exposure operation for transferring an image of the pattern PA formed on the reticle R onto the shot regions on the wafer W.

The main frame 100 is composed of the first support plate 110 that supports the projection optical system 30, the second support plate that supports the reticle stage 20, etc. located above the projection optical system 30, and a plurality of pillars 130 that are vertically arranged between the first support plate 110 and the second support plate 120. The first support plate 110 has, as described above, the hole portion 113 that is formed a little larger than the outer diameter of the cylinder-shaped projection optical system 30. The first support plate 110 or the second support plate 120 may be coupled to the plurality of the pillars 130 by coupling means etc., or they may be integrally formed.

The main frame 100 is supported above the base frame 200 via the vibration insulating unit 66, as described above.

The base frame 200 is composed of the support plate 210 that supports the wafer stage 40 above the top surface thereof via the vibration insulating unit 70, and a plurality of pillars 220 that are vertically arranged on the support plate 210 for supporting the main frame 100 via the vibration insulating unit 66. The support plate 210 and the pillars 220 may be coupled by coupling means, etc., or may be integrally formed.

The base frame 200 is installed substantially horizontally above a floor surface F of a clean room, etc. via a foot portion 215.

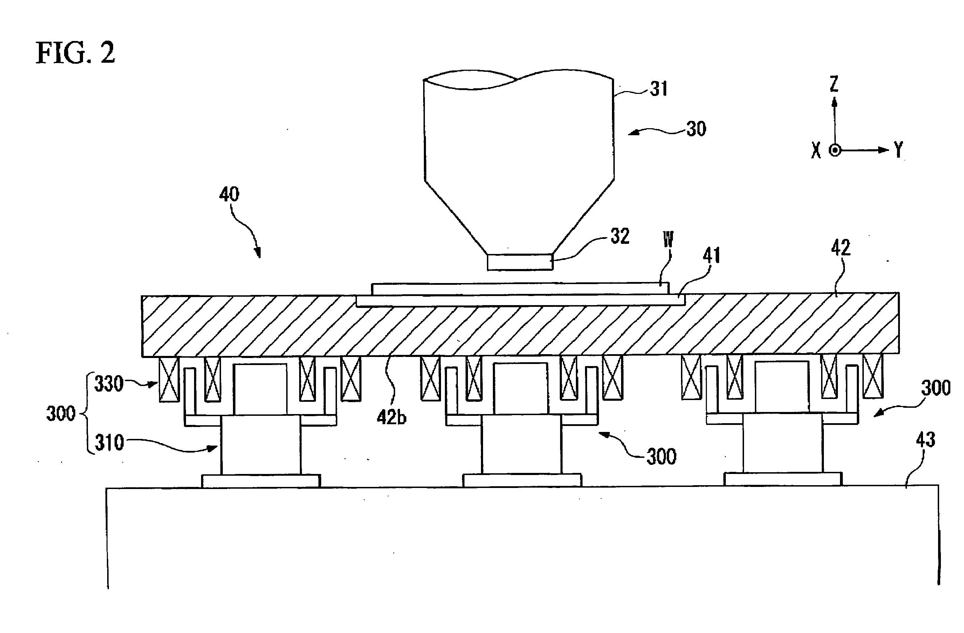

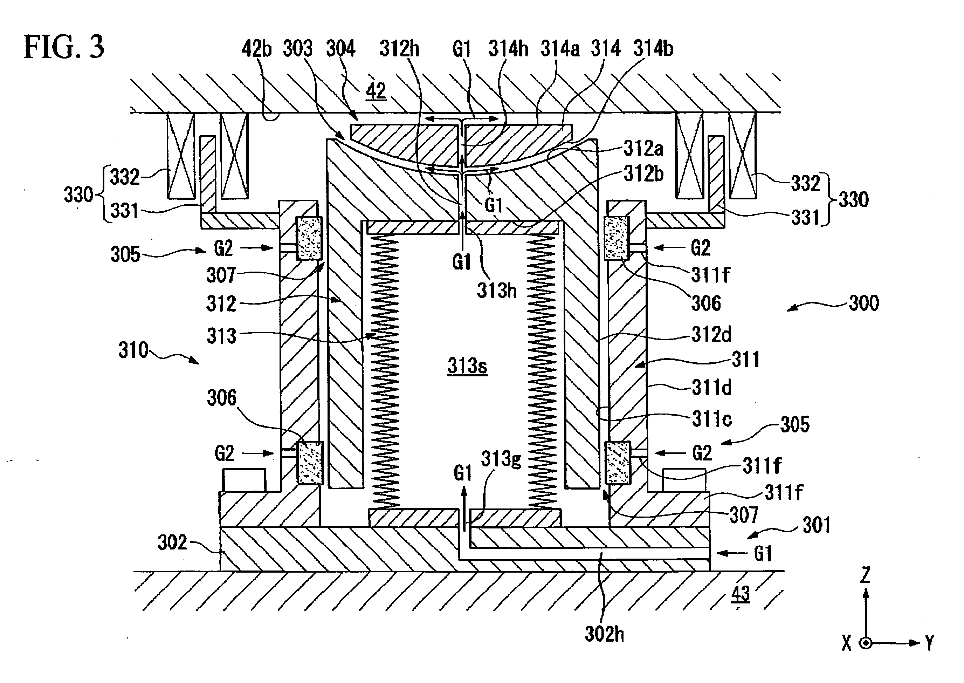

FIG. 2 is an enlarged view of the wafer stage 40. FIG. 3 is a cross-sectional view of the support apparatus 300.

As described above, the wafer stage 40 includes: the Z table (supported member, second member) 42 with the wafer holder 41 located on the top surface thereof; and the XY table (support member, first member) 43 that moves in the XY direction together with the Z table 42. Between the Z table 42 and the XY table are located three support apparatuses 300. As a result, the Z table 42 is supported on the XY table 43 at three points.

The support apparatus 300 is composed of a self-weight support portion 310 and a drive portion 330.

The self-weight support portion 310 includes a piston 312 and a cylinder 311. The cylinder 311 is made of a cylindrical member with a flange portion 311f at one end. The cylinder 311 is fixed on the XY table 43 with a gas supply portion disk 302 sandwiched between the flange portion 311f and the XY table 43. The piston 312 is made of a cup-shaped member, and is fitted inside the cylinder 311 to be pivotally supported in a manner movable in the direction of gravitational force (Z direction, first direction). The gas supply portion disk 302, the cylinder 311, and the piston 312 form an inner space inside the cylinder 311. In the inner space is contained a bellows 313, which will be described later.

A swivel (intermediate member) 314 is set on a top surface 312a of the piston 312. The top surface 312a of the piston 312 is formed in a concave-lens-like shape. On the other hand, the bottom surface 314b of the swivel 314 is formed in a convex-lens-like shape. The top surface (support surface) of the swivel 314 is formed flat, and faces the bottom surface 42b of the Z table 42.

Note that the cylinder 311, the piston 312, and the swivel 314 are made of an alumina, etc. However, the material is not limited thereto.

Between an inner peripheral surface (inner wall) 311 c of the cylinder 311 and an outer peripheral surface (outer wall) 312d of the piston 312, between the top surface 312a of the piston 312 and the bottom surface 314b of the swivel 314, and between the top surface 314a of the swivel 314 and the bottom surface 42b of the Z table 42, pressurized gases (fluids, pressurized airs) G1, G2 are respectively supplied from gas supply systems 301, 305 (described later) to form aerostatic bearings 303, 304, 307 between each of the paired members. As a result, the piston 312 is contactlessly and pivotally supported by the cylinder 311 (constrained in the XY direction), The swivel 314 is contactlessly and rotatably supported in directions of three degrees of freedom (θX, θY, θZ) with respect to the piston 312. The Z table 42 is contactlessly and parallel-movably supported with respect to the swivel 314. Groove(s) (not shown) for forming a surface restrictor type aerostatic bearing 304 are provided on the top surface 314a and bottom surface 314b of the swivel 314,

Therefore, the support apparatus 300 supports the Z table 42 in directions of six degrees of freedom by the supply of the pressurized gases G1, G2.

The bellows (outer envelope) made of metal (e.g., stainless steel) is contained in the inner space of the cylinder 311. The bellows 313 is a bag-like accordion member freely extendable in the Z direction. The pressurized gas G1 is supplied to the inner space (pressure chamber) 313s thereof. As a result, the bellows 313 extends in the Z direction to push up the piston 312 in the+Z direction. That is, the pressure of the pressurized gas G1 supplied to the inner space 313s is converted into a biasing force in the Z direction. The biasing force supports the Z table 42 in the direction of gravitational force via the piston 312 and the swivel 314.

Therefore, by use of the support apparatus 300, the self-weight of the Z table 42 and the supporting force by the support apparatus 300 are in balance. That is, the self-weight of the Z table 42 is compensated (cancelled), The lower end of the bellows 313 is fixed to the gas supply portion disk 302 exposed to the bottom of the cylinder 311. Furthermore, the upper end thereof is fixed to the bottom surface 312b of the piston 312,

In the gas supply portion disk 302 to which the bottom surface of the bellows 313 is fixed, a through-hole 302h is provided that penetrates from the outer peripheral surface of the gas supply portion disk 302 to the central portion of the top surface thereof At the center of the bottom surface of the bellows 313 is provided an opening 313g with substantially the same diameter as that of the through-hole 302h. The gas supply portion disk 302 and the bellows 313 are tightly attached such that the through-hole 302h and the opening 313g are aligned. As a result, the pressurized gas G1 from an external pressurized gas supply apparatus (not shown) is introduced to the inside of the bellows 313.

Similarly, an opening 313h is formed in the top surface of the bellows 313, In the piston 312 is provided a through-hole 312h penetrating from the bottom surface 312b to the top surface 312a so as to be aligned with the opening 313h. Furthermore, in the swivel 314 is provided a through-hole 3 I4h penetrating from the top surface 314a to the bottom surface 314b.

Therefore, the pressurized gas G1 supplied to the inner space 313s of the bellows 313 is supplied to the gap between the piston 312 and the swivel 314 via the through-hole 312h to form the aerostatic bearing (second fluid bearing) 303. Furthermore, a part of the pressurized gas G1 supplied to the gap between the piston 312 and the swivel 314 is supplied to the gap between the swivel 314 and the Z table 42 via the through-hole 314h to form the aerostatic bearing (third fluid bearing) 304.

Thus, in the support apparatus 300, a gas supply system (first supply apparatus) 301 is formed that supplies the pressurized gas G1 to the inner space 313s of the bellows 313, to the gap between the piston 312 and the swivel 314, and to the gap between the swivel 314 and the Z table 42.

Note that the pressurized gas G1 supplied from the gas supply system 301 is released to the outside via the gap between the piston 312 and the swivel 314 or the gap between the swivel 314 and the Z table 42.

The pressurized gas G2 is supplied to the gap between the inner peripheral surface 311 c of the cylinder 311 and the outer peripheral surface 312d of the piston 312 from a gas supply system (second supply apparatus) 305 that is different from the above-described gas supply system 301. As shown in FIG. 3, annular porous bodies 306 are located on the inner peripheral surface 311c of the cylinder 311. The pressurized gas G2 is supplied to the porous bodies 306 from the external gas supply apparatus (second supply apparatus) 305 via a plurality of through-holes 311h bored from the outer peripheral surface 311d of the cylinder 311 toward the inner peripheral surface 311 c thereof.

As a result, a porous restrictor type aerostatic bearing (fluid bearing) 307 can be formed in the gap between the inner peripheral surface 311c of the cylinder 311 and the outer peripheral surface 312d of the piston 312. The use of annular porous bodies 306 eliminates the need for machining, for example, forming groove(s) on the inner peripheral surface 311 c of the cylinder 311 or the outer peripheral surface 312d of the piston 312. Therefore, the aerostatic bearing 307 can be formed with ease. The porous bodies 306 are not limited to being located at two positions the upper and lower end portions, on the inner peripheral surface 311c of the cylinder 311, as shown in FIG. 3. For example, the porous bodies may be located on all the area between the upper end portion and the lower end portion of FIG. 3 so as to cover the entirety of the inner peripheral surface 311c.

The aerostatic bearing (fluid bearing) 307 is not limited to a type that uses the cylindrical (annular) porous bodies 306 as shown in FIG. 3. Another type may be used in which, for example, orifice(s) and groove(s) are combined. In this case, for example, the surface (outer peripheral surface 312d) of the piston 312 made of an alumina may be subjected to groove machining to supply the fluid from inside the piston.

The self-weight support portion 310 has the gas supply system 301 that supplies the pressurized gas G to the bellows 313, etc. and the gas supply system 305 that supplies the pressurized gas G to the gap between the piston 312 and the cylinder 311, the supply systems 301,305 being independent of each other. Therefore, the pressurized gases G1, G2 with different pressure can be supplied to the respective gas supply systems 301, 305. For example, increasing only the pressure of the pressurized gas G2 from the gas supply system 305 can improve the stiffness of the aerostatic bearing 307 formed in the gap between the piston 312 and the cylinder 311 without changing the support position of the Z table 42 in the Z direction. Furthermore, the pressurized gas G1 supplied from the gas supply system 301 is directly supplied to the inner space 313s of the bellows 313. Therefore, response of the bellows to extension and contraction (movement of the piston 312 and the Z table in the Z direction) is improved when the pressure of the pressurized gas G1 supplied from the gas supply system 301 is changed.

The drive portion (actuator) 330 is a voice coil motor composed of a coil (stator) 331 located on the upper end outer peripheral surface of the cylinder 311 and annular permanent magnets (rotors) 332 located on the bottom surface 42b of the Z table 42 correspondingly to the coil 331. The coil 331 may be located on the bottom surface 42b of the Z table 42 and the permanent magnets 332 may be located on the cylinder 311. In FIG. 3, the gap between the coil 331 and the permanent magnet 332 is not wide. As a result, travel of the Z stage 42 in the Y direction is limited within the gap to avoid contact between the two. Therefore, when the travel of the Z stage 42 in the horizontal direction (in the XY plane) with respect to the XY table 43 is elongated, the configuration of the drive portion 330 may be appropriately modified such that the coil 331 and the permanent magnets 332 can relatively move without coming into contact with each other.

The drive portion 330 can finely move the Z table 42 in the Z direction (direction of gravitational force) with respect to the XY table 43 to which the support apparatus 300 is fixed. As the drive portion 330 moves the Z table 42 up and down, the bellows 313 extends and contracts accordingly. At this time, the pressurized gas G1 in the pressure chamber 313s is controlled by the gas supply system 301 so as to increase and decrease in volume corresponding to the fluctuation in volume of the pressure chamber resulting from the extension and contraction of the bellows 313. As a result, a force in the Z direction generated in the pressure chamber 313s is maintained substantially constant irrespective of the position of the piston 312 in the Z direction. Therefore, if the Z table 42 is adjusted to support its self weight only by a force generated in the pressure chamber 313s when the Z table 42 is in normal condition, electric power consumed by the drive portion 330 can be saved. Since the Z table 42 is supported movably in directions of six degrees of freedom in a state that the self-weight of the Z table 42 is compensated (cancelled) by the drive portion 330, the drive portion 330 can finely move the Z table 42 in the Z direction with a little force. Therefore, power consumption by the drive portion 330 can be tremendously reduced.

As shown in FIG. 2, the wafer stage 40 is provided with three support apparatuses 300 arranged in parallel at three different spots between the Z table 42 and the XY table 43. Therefore, the wafer stage 40 can finely move the Z table 42 while supporting it in the Z direction. As a result, the position in the Z direction (focus position) of the wafer W held on the Z table 42 can be controlled with a low electric driving power. Furthermore, the inclination angle (θX and θY directions) of the wafer W can also be controlled with a low electric driving power by making the three support apparatuses 300 cooperate with one another.

Thus, the wafer stage 40 can control the focus position and inclination angle of the wafer W to make the surface of the wafer W coincide with the image plane of the projection optical system 30 by means of the autofocus system and the autoleveling system.

An embodiment of the present invention has been described above. However, operational procedures, or shapes, combinations, etc. of the constituent members illustrated in the above-described embodiment are merely examples, and various modifications based on process conditions, design requirements and the like can be made without departing from the spirit or scope of the present invention. The present invention includes, for example, the following modifications.

In the above-described embodiment, the configuration was described in which the three support apparatuses 300 are located between the Z table 42 and XY table 43 of the wafer stage 40. However, the configuration is not limited thereto.

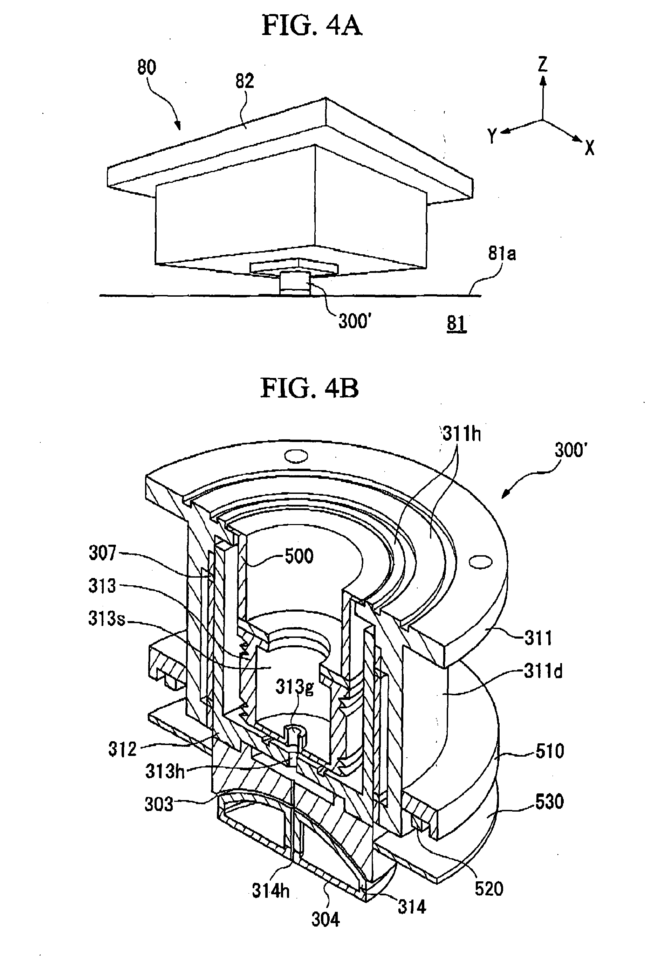

For example, as shown in FIG. 4A, it can be configured such that an XYZ table 82 is contactlessly supported above the wafer faceplate (base) 81 in a state with the self-weight of the XYZ table 82 being compensated (cancelled). The stage apparatus 80 of FIG. 4A includes: the XYZ table 82 (drive mechanism not shown) that is integrally constituted by a Z table 42 and an XY table 43 and is movable in six degrees of freedom; and a support apparatus 300' located between the XYZ table 82 and the wafer faceplate 81. The XYZ table can be moved and positioned along a guide face 81 a of the wafer faceplate 81.

FIG. 4B is a cross-sectional perspective view showing a configuration of the support apparatus 300' used in the stage apparatus 80 of FIG. 4A, In FIG. 4B, like constituent parts with like functions to those of FIGS. 1 to 3 are designated with like reference numerals, and description thereof is appropriately omitted.

In the support apparatus 300' of FIG. 4B, a cylinder 311 is fixed to an XYZ table 82 that corresponds to the above-mentioned supported member, and a piston 312 and a swivel 314 are located between a wafer faceplate 81 that corresponds to the above-mentioned support member. The cylinder 311 is fixed to the bottom surface of the XYZ table 82 via two O-rings (not shown) by means of bolts, etc. On the surface for the fixation of the cylinder 311, two grooves 311h are formed for locating the O-rings. Inside the cylinder 311 is provided a cylindrical recess portion opening in the +Z direction, in which a cup-formed piston 312 is located. A bellows 313 is located inside the recess portion, and the lower end (-Z direction end) of the bellows 313 and the bottom of the recess portion are secured. The upper end (+Z direction end) of the bellows is attached to a spacer 500 via which it is fixed to the bottom surface of the XYZ table 82. The spacer 500 is for absorbing the imbalance of the length of the bellows in the height direction (Z direction). It has a space inside that communicates with a pressure chamber 313s of the bellows 313. A pressurized gas G1 supplied from the gas supply system 301 is adapted to reach the pressure chamber 313s after passing through the inside of the spacer 500. The piston 312 is pivotally supported by a porous restrictor type fluid bearing 307 formed between the inner peripheral surface of the cylinder 311 and the outer peripheral surface of the piston 312 so as to relatively move in the Z direction with respect to the cylinder 311. The -Z side end portion of the piston 312 is formed in a concave-lens shape and faces the swivel 314 via an aerostatic bearing 303. The swivel 314 faces, at the +Z side end portion, the piston 312 via the aerostatic bearing 303 while at the same time facing, at the -Z side end portion, a guide face 81a of a wafer faceplate 81 via an aerostatic bearing 304.

The pressurized gas G1 to be supplied to the pressure chamber 313s and the pressurized gas G2 to be supplied to the aerostatic bearing 307 are adapted to be independently supplied from the XYZ table 82 side. The pressurized gas G1 is adapted to be supplied from the pressure chamber 313s to the aerostatic bearing 303 via openings 313g, 313h and a through-hole 312h, and to the aerostatic bearing 304 via a through-hole 314h in addition to the openings 313g, 313h and the through-hole 312h.

The support apparatus 300' of FIGS. 4A and 4B is configured such that the support apparatus 300 shown in FIGS. 2 and 3 is inverted in the up-down direction (Z direction). Therefore, a force to push up the cylinder 311 in the +Z direction with respect to the piston 312 is generated by the pressurized gas (pressurized air) G1 in the pressure chamber 313s of the bellows 313. The XYZ table 82 is then supported movably in directions of six degrees of freedom with respect to the wafer faceplate 81 in a state that the self-weight of the XYZ table 82 is compensated (cancelled) by the support apparatus 300'. As a result, a mechanism (not shown) for the Z direction drive of the XYZ table 82 can also enjoy the advantage that the power consumption thereof can be reduced.

The support apparatus 300' further includes a stiffness canceling apparatus that relieves the stiffness of the bellows 313 in the Z direction by a magnetic force. The stiffness canceling apparatus is provided with a magnet 520, a yoke 510, and a magnetic body 530, each of which is formed in an annular shape. The magnet 520 is fixed to the yoke 510, which is fixed to an outer peripheral surface 311d of the cylinder 311. The magnetic body 530 is secured to an outer peripheral surface (the part, exposed from the cylinder 311, on which the aerostatic bearing 307 is not formed) of the piston 312 with an adhesive, etc. The inner surface of the yoke 510 is threaded so as to move in the up-down direction (Z direction) when fixed to the outer peripheral surface 311 d of the cylinder 311. This allows adjustment of the distance between the magnet 520 and the magnetic body 530. Since the magnet 520 attracts the magnetic body 530, a force in the contraction direction acts on the bellows 313. On the other hand, the bellows 313 is already under the action of a force in the extension direction. Therefore, the stiffness of the bellows 313 is cancelled by a magnetic force of the magnet 520. In case of variation in stiffness of various bellows due to individual difference, the magnitude of magnetic force for the weight cancellation is adapted to be adjusted by changing the position of the yoke 510.

The swivel 314 .may be shaped as a hollow without the through-hole 314h portion for reducing weight. In this case, a flat surface portion (aerostatic bearing 304 side) and a spherical surface portion (aerostatic bearing 303 side) may be separately made and the two may be brazed.

The support apparatuses 300, 300' are not limited to be used for supporting the weight of a supported member (in the Z direction). The support apparatuses 300, 300' may be used as clamp apparatuses for pressing a supported member against another member. For example, six support apparatuses may be located on a supported member: three in the +X direction, two in the +Y direction, and one on the side surface. Thus, the supported member may be fixed by being pressed against another member.

The description has been made of the case in which the pressurized gas G1 is supplied from the gas supply system 301 via the inner space 313s of the bellows to the aerostatic bearing 303 between the piston 312 and the swivel 314 and to the aerostatic bearing 304 between the swivel 314 and the Z table 42. However, the configuration is not limited thereto.

It may be configured such that the pressurized gas G2 supplied from the gas supply system 305 to the aerostatic bearing 307 is partly or wholly supplied to the aerostatic bearing 303 and the aerostatic bearing 304.

Furthermore, the aerostatic bearings 303, 304 may be pressurized type bearings. In this case, pressurization may be generated by vacuum, magnetic force, etc. For example, when a vacuum pressurized type bearing is adopted, a passage connected to a vacuum source may be formed inside the support apparatus 300 or 300' independently of the passage of the pressurized gas G1 or G2. When a magnetism pressurized type bearing is adopted, a magnet may be located on any one of the swivel 314, the piston 312, the Z table 42, and the wafer faceplates 44, 81, and a member (magnetic body) such as an iron piece may be located on the opposite site to generate magnetic attraction.

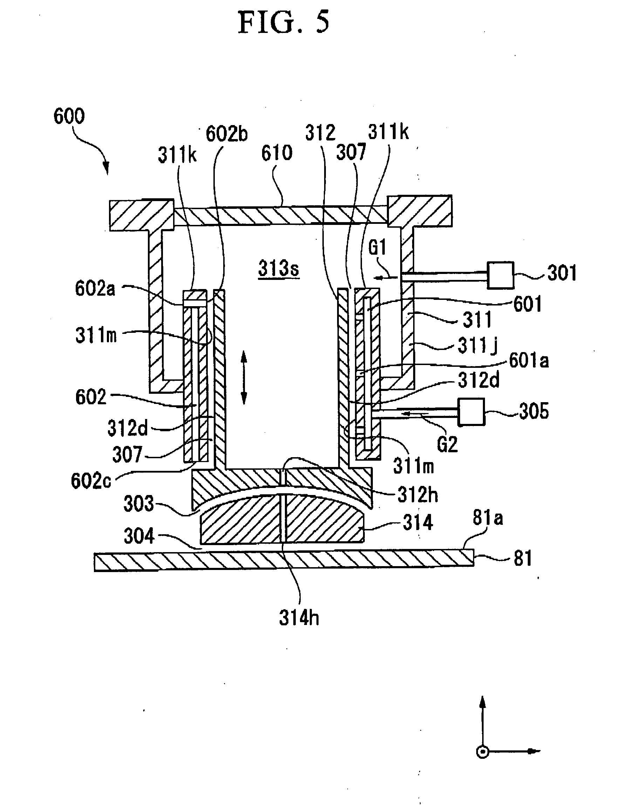

FIG. 5 is a cross-sectional view showing a configuration of a support apparatus 600 used in the stage apparatus 80 of FIG 4. It is an embodiment that does not use the bellows 313 as shown in FIGS. 3, 4B. In FIG 5, like constituent parts with like functions to those of FIGS. 1 to 4B are designated with like reference numerals, and the description thereof is appropriately omitted.

In the support apparatus 600 of FIG. 5, a cylinder 311 is fixed to an XYZ table 82. A piston 312 and a swivel 314 are located between the cylinder 311 and a faceplate 81.

The cylinder 311 has a cylinder proper 311j and a cylindrical bearing support portion 311k. A bearing surface is formed on at least a part of an inner peripheral surface 311 m of the bearing support portion 311k. It is configured such that a piston 312 is inserted so as to face the bearing surface. That is, an aerostatic beating 307 is formed between the inner peripheral surface 311m of the bearing support portion 311k and an outer peripheral surface 312d of the piston 312. The aerostatic bearing 307 may be of a porous restrictor type or an orifice type. The type is not particularly limited.

In the support apparatus 600 of FIG. 5, a pressure chamber 313s is formed by a space surrounded by the cylinder 311 and a cover 610 that lids the upper opening of the piston 312 and of the cylinder 311. A pressurized gas G1 supplied from a first supply apparatus 301 reaches the pressure chamber 313s after passing through an introduction portion provided in the cylinder proper 311j. The piston 312 is pivotally supported by the aerostatic bearing 307 formed between the inner peripheral surface 311m of the bearing support portion 311k and an outer peripheral surface 312d of the piston 312 so as to relatively move in the Z direction and the θZ direction with respect to the cylinder 311. The -Z side end portion of the piston 312 faces the swivel 314 via a second fluid bearing 303. The swivel 314 faces, at the +Z side end portion, the piston 312 via the second fluid bearing 303 while at the same time facing, at the -Z side end portion, a guide face 81a of a wafer faceplate 81 via an aerostatic bearing 304.

Two types of passage (first passages 601 and second passages 602) are formed inside the bearing support portion 311k. The first passages 601 are connected with a gas supply system 305. It is configured such that each of the first passages 601 supplies a second pressurized gas G2 to the fluid bearing 307 via a plurality of supply portions 601 a. Each of the second passages 602 is provided, at one end, with openings 602a, 602b that are respectively connected with a pressure chamber 313s and the aerostatic bearing 307 and, at the other end, with an opening 602c that is open to atmospheric pressure. The second passages 602 reduce influence caused by the interference between the fluid in the pressure chamber 313s and the fluid supplied to the aerostatic bearing 307 even when there is a pressure difference between the two. Shapes, arrangements, etc. of each of the openings 602a, 602b, 602c for the second passages 602 can be appropriately determined according to the configuration, etc. of the support apparatus 600 so as to reduce the influence of the above-mentioned interference. For example, only one of the two fluids may be forcefully sucked with a vacuum apparatus, etc.

A plurality of the first passages 601 are provided concentrically inside the bearing support portion 311k, at least one of which is connected with the gas supply system 305. A passage (not shown) is provided that communicates with the first passages 601 for supplying the second pressurized gas G2 from the gas supply system 305 to each of the first passages 601. A plurality of the second passages 602 are provided also concentrically inside the bearing support portion 311k in a manner that they do not interfere with the first passages 601. In FIG. 5, the right half side of the central axis shows a cross-sectional view including the first passage 601, and the left half shows a cross-sectional view including the second passage 602. Note that the configuration of the first passages 601 and the second passages 602 is not limited to that of FIG. 5, but may be appropriately determined according to the configuration of the support apparatus 600.

Even in such a support apparatus 600, as is the configuration of FIG: 4B, a first pressurized gas G1 to be supplied to the pressure chamber 313s and the pressurized gas G2 to be supplied to the aerostatic bearing 307 are adapted to be independently supplied from the XYZ table 82 side. Furthermore, the pressurized gas G1 is adapted to be supplied from the pressure chamber 313s to the second fluid bearing 303 via the through-hole 312h, and to the third fluid bearing 304 via the through-hole 314h in addition to the through-hole 312h.

In the configuration of FIG 3 and FIG 4B, the cylinder 311 (XYZ table 82 side) and the piston 312 are connected via the bellows 313. However, in the support apparatus 600 of FIG. 5, no mechanical contact is provided between the air cylinder 311 and the piston 312. Therefore, transmission of vibration from a faceplate 81 to an XYZ table 82 can be suppressed. Furthermore, the spring stiffness of the support apparatus 600 in the Z direction can be reduced since there is no influence of the stiffness of the bellows 313 itself.

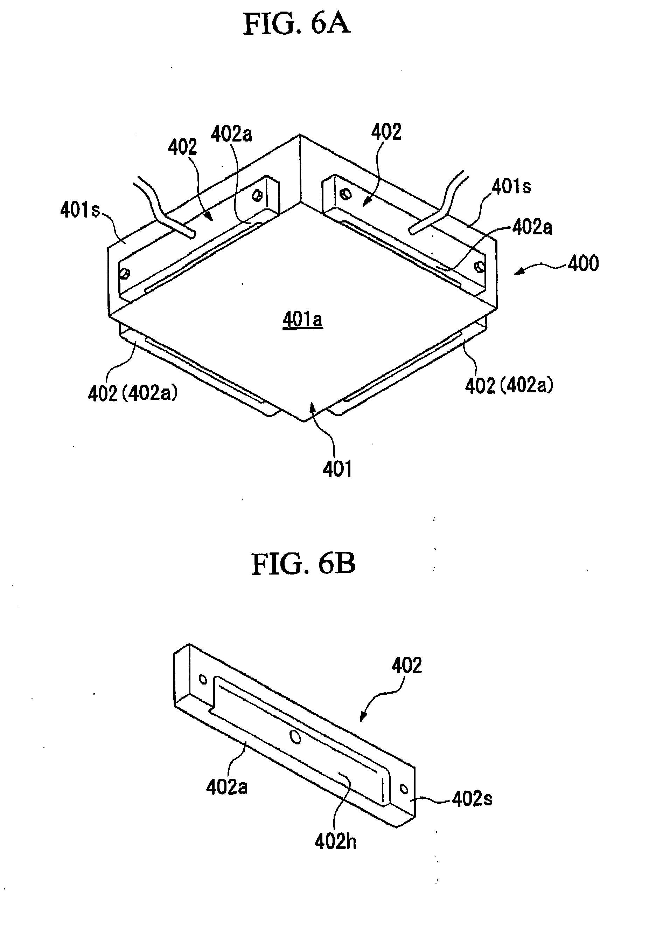

An air pad 400 shown in FIGS. 6A, 6B may be used instead of the air pad 45. FIG. 6A is a perspective view of the air pad 400 seen from a bearing side. FIG. 6B is a perspective view of a slot member 402.

The air pad 400 has slot restrictors. A slot restrictor is for obtaining a strong restrictive effect by making fluid resistance higher with a passage having an extremely narrow space (about 5 to 20 µm). Since it can offer high stiffness and has no grooves on the bearing surface, a slot restrictor features a high stability against the pneumatic hammer phenomenon. However, there are problems that it is difficult to form a narrow space and that mass productivity of slot restrictors is inferior to that of others.

To address such problems, the air pad 400 forms slot restrictors by attaching slot members 402, by means of bolts, etc., to side surfaces 401s of a bearing member 401 having a bearing surface 401a. That is, the side surfaces 401s of the bearing member 401 are formed flat. On the other hand, a dug portion 402h (see FIG. 6B) about 5 to 20 µm deep is formed in a side surface 402s of a slot member 402. By tightly attaching a side surface 401s of the bearing member 401 to a side surface 402s of the slot member 402, a slot restrictor is formed between the bearing surface 401a of the bearing member 401 and the bearing surface 402a of the slot member 402 (see FIG. 6A). In this way, slot members 402 are attached to the four side surfaces 401s of the bearing member 401 and a fluid (gas) is supplied to the slot restrictors to form the air pad 400.

Since the air pad 400 forms slot restrictors by attaching the slot members 402 to the bearing member 401, the slot restrictors can be disassembled, which facilitates maintenance of the restrictor portions. Furthermore, the stiffness of the air pad 400 can be changed by replacing the slot members with other slot members with a different digging depth to modify the slot width.

By arranging a plurality of such air pads 400 on the bottom surface of the XY table 43, the XY table 43 can be supported above the wafer faceplate 44 in a contactless and highly stiff manner.

The present invention is also applicable to an exposure apparatus including a plurality of stages independently movable in the XY directions in a state with substrates to be processed such as a wafer located thereon on a one-on-one basis as disclosed in, for example, Japanese Unexamined Patent Publication, First Publication No. H10-163099 and Japanese Unexamined Patent Publication. First Publication No. H10-214783 (corresponding to U.S. Patent No. 6,400,441), Published Japanese Translation No. 2000-505958 of PCT International Application (corresponding to U.S. Patent No. 5,696,411 and U.S. Patent No. 6,262,796). As far as is permitted by the national law of the country specified (or selected) in this patent application, the disclosures of the above-mentioned Japanese patent publications or U.S. patents are incorporated herein by reference.

The present invention is also applicable to an exposure apparatus including:
an exposure stage that is movable while holding a substrate to be processed such as a wafer; and a measurement stage provided with various measurement members and
sensors. Such an exposure apparatus is disclosed in, for example, Japanese Unexamined Patent Publication, First Publication No. H11-135400. As far as is permitted by the national law of the country specified (or selected) in this patent application, the disclosures of the above-mentioned Japanese patent publication is incorporated herein by reference.

In the above-described embodiments, an optical transmission type mask formed with a predetermined shielding pattern (or phase pattern or dimming pattern) on an optical transmission substrate or an optical reflective type mask formed with a predetermined reflective pattern on an optical reflective substrate is used. However, the type is not limited thereto. For example, instead of such a mask, an electronic mask (one type of optical system) for forming a transmission pattern or reflection pattern, or a light emitting pattern, based on electronic data of a pattern to be exposed may be used. Such an electronic mask is disclosed in, for example, U.S. Patent No. 6,778,257. As far as is permitted by the national law of the country specified (or selected) in this patent application, the electronic mask in the above-mentioned U.S. patent is incorporated herein by reference. Note that the above-described electronic mask represents an idea including both of a non-emissive type image display element and a self-emissive type image display element.

Furthermore, the present invention is also applicable to such an exposure apparatus that uses a so-called two-beam interference exposure in which interference fringes generated by interference of a plurality of light beams are exposed onto a substrate. Such an exposure method and an exposure apparatus are disclosed in, for example, PCT International Patent Publication No. WO01/35168 pamphlet. As far as is permitted by the national law of the country specified (or selected) in this patent application, the disclosures in the above-mentioned pamphlet is incorporated herein by reference.

Furthermore, the present invention is also applicable to a liquid immersion exposure apparatus that performs exposure in a condition that the space between a projection optical system PL and a substrate (wafer) W is filled with a liquid. As for such a liquid immersion exposure apparatus, one disclosed in PCT International Patent Publication No. WO2004/053958 pamphlet is known in which the space between the projection optical system 30 and the substrate W is locally filled with a liquid, As far as is permitted by the national law of the country specified (or selected) in this patent application, the disclosures in the above-mentioned pamphlet is incorporated herein by reference. The present invention is also applicable to a liquid immersion exposure apparatus that moves, in a liquid bath, a stage holding a substrate (wafer) W to be exposed and to a liquid immersion exposure apparatus that forms, on a stage, a liquid bath with a predetermined depth for holding a substrate W therein. The configuration and exposure operations of a liquid immersion exposure apparatus that moves, in a liquid bath, a stage holding a substrate to be exposed are disclosed in, for example, in Japanese Unexamined Patent Publication, First Publication No. H06-124873, and a liquid immersion exposure apparatus that forms, on the stage, a liquid bath with a predetermined depth for holding a substrate therein is disclosed in, for example, in Japanese Unexamined Patent Publication, First Publication No. H10-303114 and U.S. Patent No. 5,825,043. As far as is permitted by the national law of the country specified (or selected) in this patent application, the disclosures of the above-mentioned Japanese patent publications or U.S. patent are incorporated herein by reference.

The configuration of the exposure apparatus is not limited to that in which a substrate (wafer) W is exposed in a condition that an optical path on a light emitting side of a final optical member of the projection optical system 30 is filled with a liquid (pure water). As is disclosed in PCT International Patent Publication No. W02004/019128 pamphlet, it may be configured such that an optical path on a light entrance side of the final optical member of the projection optical system is also filled with a liquid (pure water). As far as is permitted by the national law of the country specified (or selected) in this patent application, the disclosures in the above-mentioned pamphlet are incorporated herein by reference.

In the above-described embodiments, a step-and-repeat type exposure apparatus was described by way of example. However, the present invention is also applicable to a step-and-scan type exposure apparatus. Furthermore, the present invention is applicable not only to an exposure apparatus for use in the manufacture of semiconductor elements but also to an exposure apparatus for use in the manufacture of displays including a liquid crystal device (LCD), etc. for transferring a device pattern onto a glass plate, thin film magnetic heads for transferring a device pattern onto a ceramic wafer, image pickup elements such as a CCD, etc. Moreover, the present invention is also applicable to an exposure apparatus that transfers a circuit pattern onto a glass substrate, a silicon wafer, or the like for manufacturing reticles or masks to be used in an optical exposure apparatus, an EUV exposure apparatus, an X-ray exposure apparatus, an electron beam exposure apparatus, etc. Here, in an exposure apparatus that uses a deep ultraviolet (DUV) beam , a vacuum ultraviolet (VUV) beam, or the like, a transmissive type reticle is generally used. As for a reticle substrate, a silica glass, a silica glass doped with fluorine, a fluorite, a magnesium fluoride, a crystal, or the like is used. In a proximity type X-ray exposure apparatus, an electronic beam exposure apparatus, or the like, a transmissive type mask (stencil mask, membrane mask) is used. As for a mask substrate, a silicon wafer or the like is used.

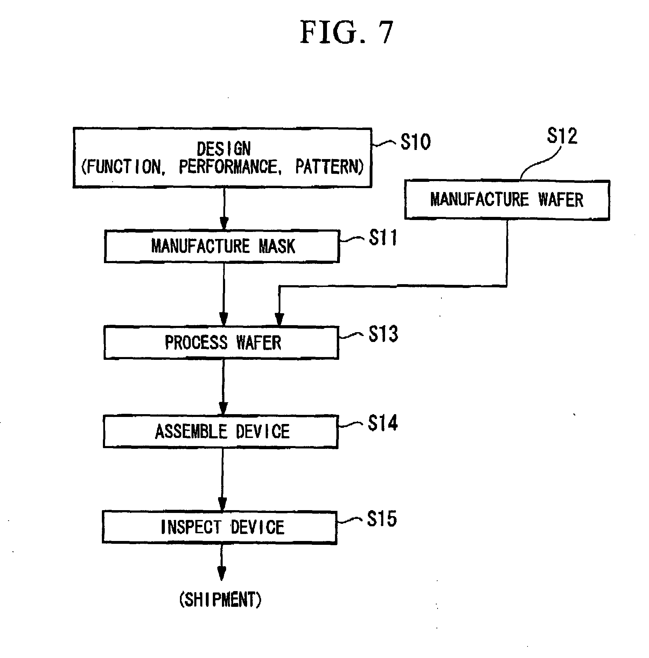

Next, an embodiment of a micro device manufacturing method will be described in which an exposure apparatus and exposure method according to the embodiments of the present invention are used in the lithography process, FIG. 7 is a flowchart showing an example of the manufacture of micro devices (semiconductor chips such as ICs or LSIs, liquid crystal panels, CCDs, thin film magnetic heads, micro machines, etc.). As shown in FIG. 7, first at STEP S10 (design step), function and performance design of a micro device (for example, circuit design of a semiconductor device, etc.) is performed and a pattern design is performed for actualizing the function. Subsequently at STEP S11 (mask creation step), a mask (reticle) formed with a designed circuit pattern is created, while at STEP S12 (wafer manufacturing step), a wafer is manufactured from a material such as a silicon.

Next at STEP S 13 (wafer processing step), the mask and wafer prepared at STEPS S10 to S12 are used to form an actual circuit, etc. on the wafer by the lithography technique, etc. as described later. Then at STEP S14 (device assembly step), the wafer processed at STEP S13 is used to assemble a device. This STEP S 14 includes steps such as a dicing step, a bonding step, and packaging step (chip loading) as required. Finally at STEP S 15 (inspection step), inspections of the micro device manufactured at STEP S14 are performed such as an operation check test and an endurance test. The micro device is completed after going through these steps and is then shipped.

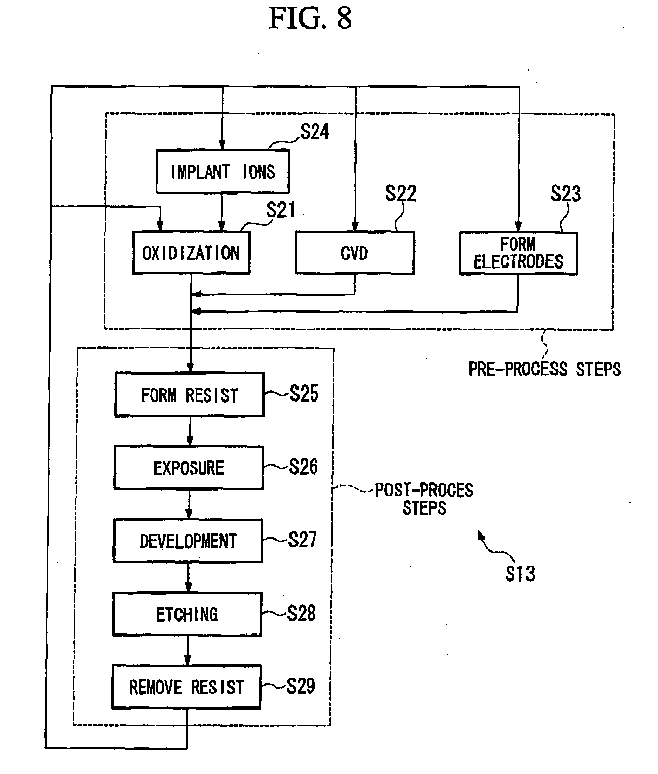

FIG. 8 shows an example of STEP S 13 in detail in the case of a semiconductor device.

At STEP S21 (oxidation step), the surface of a wafer is oxidized. At STEP S22 (CVD step), an insulating film is formed on the wafer surface. At STEP S23 (electrode formation step), electrodes are formed on the wafer by evaporation coating. At STEP S24 (ion implantation step), ions are implanted into the wafer. The above STEPS S21 to S24 respectively make up a preprocessing step for each stage of the wafer processing, and are selected and executed according to a necessary processing in each stage.

When the above-described preprocessing steps are finished at each stage of the wafer processing, postprocessing steps are executed as described below. In the postprocessing steps, first at STEP S25 (resist formation step), a photosensitive material is coated on the wafer. Subsequently at STEP S26 (exposure step), the circuit pattern of the mask is transferred onto the wafer by means of the above-described lithography system (exposure apparatus) and exposure method. Next at STEP S27 (development step), the exposed wafer is developed. At STEP S28 (etching step), the exposed member in the portions other than where the resist still remains is removed by etching. Then at STEP S29 (resist removal step), the resist becoming useless after the etching is removed. By repeating the preprocesses and the postprocesses, multiple circuit patterns are formed on the wafer.

Furthermore, the present invention is also applicable to an exposure apparatus that transfers a circuit pattern from a mother reticle to a glass substrate, a silicon wafer, or the like for manufacturing not only micro devices such as semiconductor elements but also reticles or masks for use in an optical exposure apparatus, an EUV exposure apparatus, an X-ray exposure apparatus, an electron beam exposure apparatus, etc. Here, in an exposure apparatus that uses a deep ultraviolet (DUV) beam, a vacuum ultraviolet (VUV) beam, or the like, a transmissive type reticle is generally used. As for a reticle substrate, a silica glass, a silica glass doped with fluorine, a calcium fluoride, a magnesium fluoride, a crystal, or the like is used. In a proximity type X-ray exposure apparatus, an electronic beam exposure apparatus, or the like, a transmissive type mask (stencil mask, membrane mask) is used. As for a mask substrate, a silicon wafer or the like is used. Such an exposure apparatus is disclosed in PCT International Patent Publication No. WO99/34255 pamphlet, PCT International Patent Publication No. WO99/50712 pamphlet, PCT International Patent Publication No. WO99/66370 pamphlet, Japanese Unexamined Patent Publication, First Publication No. H11-194479, Japanese Unexamined Patent Publication, First Publication No. 2000-12453, and Japanese Unexamined Patent Publication, First Publication No. 2000-29202. As far as is permitted by the national law of the country specified (or selected) in this patent application, the above-mentioned pamphlets and Japanese patent publications are incorporated herein by reference.

## Claims

1. A support apparatus comprising: a cylinder portion;
a piston portion that is provided inside the cylinder portion and is movable in a first direction;
a fluid bearing formed in at least a portion between an inner wall of the cylinder portion and an outer wall of the piston portion, the support apparatus supporting a supported member in the first direction with respect to a support member by means of a biasing force generated by the cylinder portion and the piston portion,
wherein first and second fluids are supplied independently inside the fluid bearing and the cylinder, respectively.

2. The support apparatus according to claim 1, further comprising: a first supply apparatus that supplies the first fluid inside the cylinder portion; and a second supply apparatus that supplies the second fluid to the fluid bearing, wherein a pressure of the first fluid supplied from the first supply apparatus and a pressure of the second fluid supplied from the second supply apparatus are different from each other.

3. The support apparatus according to claim 2, further comprising a pressure chamber provided inside the cylinder portion, wherein the first supply apparatus supplies the first fluid to the pressure chamber.

4. The support apparatus according to claim 3, wherein the pressure chamber is provided independently of the cylinder portion and has an outer envelope extendable in the first direction.

5. The support apparatus according to claim 4, wherein the piston portion is connected with the outer envelope.

6. The support apparatus according to any one of claims 3 to 5, wherein a reduction mechanism is provided that reduces an interference between the first fluid in the pressure chamber and the second fluid supplied to the fluid bearing.

7. The support apparatus according to any one of claims 3 to 6, wherein the first and second fluids are prevented from moving between the pressure chamber and the fluid bearing.

8. The support apparatus according to claim 6 or claim 7, further comprising a pressure release portion connected with the pressure chamber and the fluid bearing.

9. The support apparatus according to any one of claims 2 to 8, wherein the fluid bearing has a porous body provided on at least either one of the inner wall of the cylinder portion and the outer wall of the piston portion, and the second supply apparatus supplies the second fluid to the porous body.

10. The support apparatus according to any one of claims 2 to 9, further comprising:
an intermediate member located on one end of the piston portion and inclinable with respect to a plane that intersects the first direction; and
a second fluid bearing formed between the piston portion and the intermediate member,
wherein the second bearing is supplied with the first fluid and/or the second fluid from at least either one of the first supply apparatus and the second supply apparatus.

11. The support apparatus according to claim 10, wherein the intermediate member has a support plane that supports a support member or a supported member, and a relative movement is allowed between the support member or the supported member and the support plane with respect to a direction that intersects the first direction.

12. The support apparatus according to any one of claims 1 to 11, wherein the cylinder portion is connected with the support member.

13. The support apparatus according to any one of claims 1 to 11, wherein the cylinder portion is connected with the supported member.

14. The support apparatus according to any one of claims 1 to 12, wherein an actuator that generates a force substantially parallel with the first direction is provided between the support member or the supported member and the cylinder portion.

15. A stage apparatus, comprising: a first member; and a second member that is supported movably with respect to the first member by at least one support apparatus,
wherein the support apparatus is a support apparatus according to any one of claims 1 to 14, and
the second member includes at least a part of the supported member.

16. A stage apparatus movable on a base with a guide face, comprising a support apparatus according to claim 13,
the stage apparatus being supported on the base by means of the support apparatus.

17. An exposure apparatus comprising: a mask stage with a mask; and a substrate stage that holds a substrate, the exposure apparatus exposing a pattern formed on the mask onto the substrate,
wherein the stage apparatus according to claim 15 or claim 16 is used for at least either one of the mask stage and the substrate stage.

18. A device manufacturing method comprising a lithography process, wherein the exposure apparatus according to claim 17 is used in the lithography process.
